# EUROPEAN PATENT APPLICATION

(11) **EP 4 586 765 A1**
(43) Date of publication of application: **16.07.2025**
(21) Application number: 24222369.1
(22) Date of filing: 20.12.2024
(51) Int. Cl.: H10D 30/01, H10D 30/47, H10D 62/17, H10D 64/00, H10D 62/85

(54) **SEMICONDUCTOR DEVICE AND METHOD OF MANUFACTURING THE SAME**

(30) Priority: 12.01.2024 US 202418411451
(71) Applicant: STMicroelectronics International N.V., 1228 Plan-les-Ouates, Geneva (CH)
(72) Inventor: CAPELLI, Daniele, 20060 BASIANO (MI) (IT)
(74) Representative: Studio Torta S.p.A.

(57) **Abstract**

The semiconductor device (100) comprises a substrate (102) made of a semiconductor material, a gate structure (104) placed on the substrate, a passivation layer (106) placed on the substrate and on a portion of the gate structure, a sealing oxide layer (108) placed on the passivation layer, a first field plate (112) placed on a portion of the sealing oxide layer, a dielectric layer (114) placed on the first field plate and on the sealing oxide layer, a second field plate (132) placed on a portion of the layer, and a source contact metallization (124) and a drain contact metallization (126). The sealing oxide layer is thicker than the passivation layer.

## Description

### FIELD OF THE INVENTION

The present invention relates generally to structures for semiconductor devices and, more particularly, to structures for gallium nitride (GaN) high electron mobility transistor (HEMT) devices.

### BACKGROUND

Gallium nitride (GaN) high electron mobility transistors (HEMTs) are increasingly used for power electronics, especially for some high-power applications. Applicant has identified many technical challenges and difficulties associated with manufacturing semiconductor devices, such as GaN HEMTs.

GaN HEMTs typically comprise one or more field plates. A field plate is a metallic electrode (which may be made of Titanium Nitride (TiN), Aluminum Copper (AlCu), or any other suitable material) biased to a certain voltage, used to modify and control the voltage and electric field peak along the conductive channel of the transistor. The voltage between the conductive channel and the field plate is sustained by a capacitor-like structure with a dielectric medium (typically Silicon Oxide or Silicon Nitride).

Some problems can arise during the formation (definition) of the field plate that can cause some residues (which may be termed stringers) to remain in some unwanted areas, for example at the vertical or concave walls of the ohmic (drain & source) metallizations. These residues could cause unwanted electrical effects and/or a loss of electrical performance of the HEMT. In other cases, when the Silicon Nitride (SiN) sealing layer is etched around the gate to create an opening that enables formation of the field plate, the mask to create the SiN opening may not be precisely located, thus removing too much SiN and/or too much Silicon Oxide (SiO) (in the layer below the SiN) and forming holes. Unwanted materials (e.g., TiN) may fill the holes, thus causing unwanted electrical effects and/or a loss of electrical performance of the HEMT.

The aim of the present invention is therefore to overcome the drawbacks of the prior art.

### SUMMARY

According to the present invention are provided a semiconductor device and a method of manufacturing the semiconductor devices, as defined in the annexed claims. The present disclosure is summarized hereunder.

In accordance with various examples of the present disclosure, a semiconductor device is provided. In some example, the semiconductor device comprises a substrate made of a semiconductor material, a gate structure placed on the substrate, a passivation layer placed on the substrate and on a portion of the gate structure, a sealing oxide layer placed on the passivation layer, a first field plate placed on a portion of the sealing oxide layer, a dielectric layer placed on the first field plate and on the sealing oxide layer, a second field plate placed on a portion of the layer, and a source contact metallization and a drain contact metallization. The sealing oxide layer is thicker than the passivation layer.

In another example, the dielectric layer comprises a nitride layer or an oxide layer.

In another example, the source contact metallization and the drain contact metallization formed on corresponding portions of the substrate in corresponding voids in the passivation layer, the sealing oxide layer, and the dielectric layer.

In another example, the dielectric layer comprises a first dielectric sub-layer and a second dielectric sub-layer.

In another example, the first dielectric sub-layer is partially overlapped by the source and drain contact metallizations.

In another example, the second dielectric sub-layer overlaps the source and drain contact metallizations.

In another example, the dielectric layer is a first dielectric layer and the semiconductor device further comprises a second dielectric layer placed on the second field plate and on a portion of the first dielectric layer.

In another example, the semiconductor device further comprises a gate contact metallization placed on the gate structure in a void in the second dielectric layer, the first dielectric layer, the sealing oxide layer, and the passivation layer.

In another example, the gate structure is made of gallium nitride (GaN) and the semiconductor device comprises a GaN high electron mobility transistor.

In another example, the second field plate partially contacts the first field plate through a further void in the dielectric layer.

In accordance with various examples of the present disclosure, a method for manufacturing a semiconductor device is provided. In some examples, the method comprises forming a gate structure on a substrate made of a semiconductor material, forming a passivation layer on the substrate and on a portion of the gate structure, forming a sealing oxide layer on the passivation layer, wherein the sealing oxide layer is thicker than the passivation layer, forming a first field plate on a portion of the sealing oxide layer, forming a dielectric layer on the first field plate and on the sealing oxide layer, forming a second field plate on a portion of the dielectric layer, and forming a source contact metallization and a drain contact metallization.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIGS. 1-13 are schematic cross-sectional views illustrating steps of an example method of manufacturing a semiconductor device, in accordance with some embodiments of the present disclosure;
FIG. 14 is a schematic cross-sectional view of an example semiconductor device, in accordance with some embodiments of the present disclosure; and
FIG. 15 is a schematic cross-sectional view illustrating a step of an example method of manufacturing a semiconductor device, in accordance with some alternative embodiments of the present disclosure.

### DETAILED DESCRIPTION OF THE INVENTION

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

The present disclosure provides semiconductor devices and methods of manufacturing semiconductor devices in which a passivation layer and then a gate sealing layer are applied prior to creation of a first of two separate field plates. Moreover, the present disclosure provides semiconductor devices and methods of manufacturing semiconductor devices in which creation of a first of two separate field plates is performed separately from gate metallization. Furthermore, the present disclosure provides semiconductor devices and methods of manufacturing semiconductor devices in which the sealing nitride layer is not etched for field plate creation. For example the present disclosure provides semiconductor devices and methods of manufacturing semiconductor devices in which a three-step gate contact etch is performed.

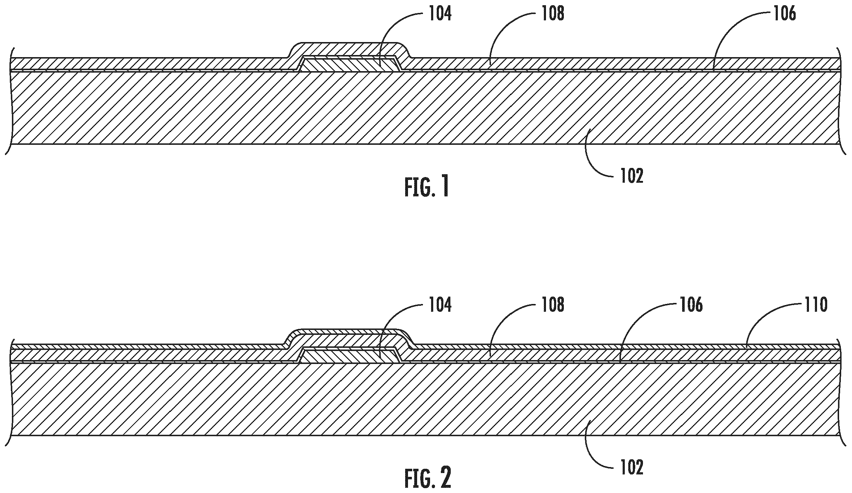

FIGS. 1-13 are schematic cross-sectional views illustrating steps of an example method of manufacturing a semiconductor device, such as a GaN HEMT. Referring now to FIG. 1, a gate structure 104 is formed on a substrate 102. The substrate 102 comprises, for example, Silicon Carbide (SiC) or Silicon (Si), which are commonly used for the substrate of a GaN HEMT. Alternatively, the substrate 102 comprises a stack of Aluminum Gallium Nitride (AlGaN) and GaN. The gate structure 104 comprises, for example, p-Type Gallium Nitride (p-GaN) with Magnesium (Mg) doping. A passivation layer 106 is formed on top of the substrate 102 and the gate structure 104. The passivation layer 106 comprises, for example, materials such as Silicon Dioxide (SiO2), Aluminum Oxide (e.g., Alumina, Al2O3), Aluminum Nitride (A1N), or Gallium Oxide (Ga2O3) (or other similar non-stoichiometric oxides). A sealing dielectric layer (which may also be termed a gate sealing dielectric layer) is deposited over the passivation layer 106. Typically, the sealing dielectric layer is made of an oxide material (such as in the following named sealing oxide layer 108). Alternatively, the sealing dielectric layer is made of a nitride material.

The sealing oxide layer 108 comprises, for example, SiO2. In an embodiment, having the passivation layer contacting the gate structure and having the gate sealing oxide layer over the passivation layer enables a thinner gate sealing oxide layer as compared to other approaches that have been used. Having a thinner gate sealing oxide layer as compared to other approaches that have been used may provide a better reduction of the peaks of the electrical field and control of the hot carrier, with consequent beneficial effects on electrical properties of the device.

In an embodiment, the sealing oxide layer 108 is thicker than the passivation layer 106. For example, the sealing oxide layer is about eight to twelve times thicker than the passivation layer (the passivation layer is typically about 5-10 nanometers thick, while the sealing oxide layer is typically about 30-120 nm, and preferably about 40-100 nm, thick). For example, the sealing oxide layer is about ten times thicker than the passivation layer. In an embodiment, the sealing oxide layer matches a target value since the sealing oxide layer is used as a dielectric for the field plate "capacitor like" structure. Too low thickness of the sealing oxide layer results in poor control of the residual sealing layer after patterning of a first field plate, while too high thickness of the sealing oxide layer results in too low capacitance value and coupling to channel of the first field plate.

Referring now to FIG. 2, a metallic layer 110 is deposited over the sealing oxide layer 108. The metallic layer 110 comprises, for example, TiN. In an embodiment, better control of the thickness of the sealing oxide layer is obtained as the only source of variability of the thickness of the sealing oxide layer is the sealing oxide deposition itself.

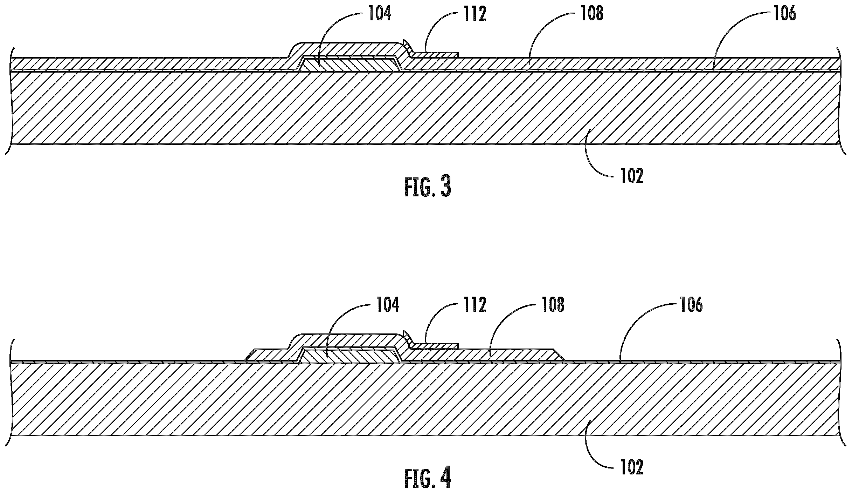

Referring now to FIG. 3, the metallic layer is patterned and etched to create a first field plate 112 by removing all of the metallic layer 110 except for the portion that forms the first field plate 112. Referring now to FIG. 4, the sealing oxide layer 108 is patterned and etched to remove unneeded material on opposing sides of the gate structure 104. In an embodiment, the sealing oxide layer 108 is protected by the first field plate 112 and therefore better overall electrical behavior of the HEMT is achieved.

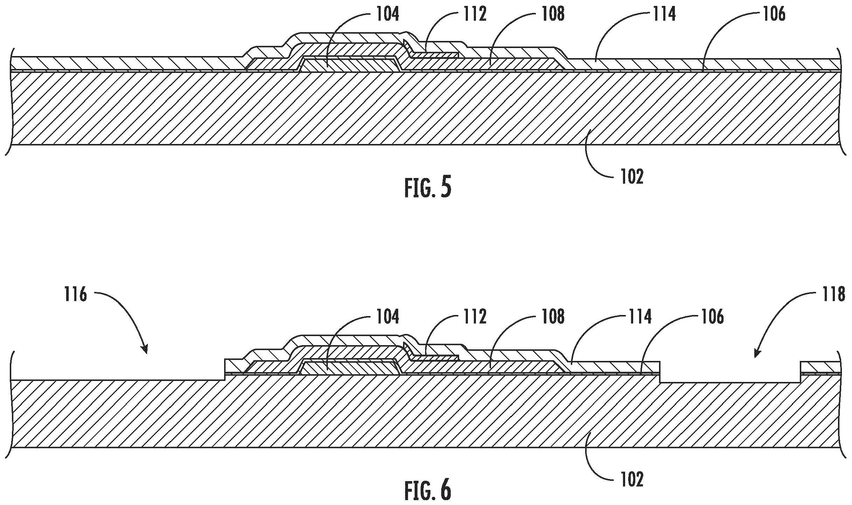

Referring now to FIG. 5, a dielectric layer comprising a first dielectric sub-layer such as a contact nitride layer 114 (which, in an alternative embodiment, is an oxide layer) is deposited over the first field plate 112, portions of the sealing oxide layer 108, and portions of the passivation layer 106. The contact nitride layer 114 comprises, for example, Silicon Nitride (SiN or Si3N4) or other dielectric such as Silicon Oxide (SiO2). This layer is termed the contact nitride layer because this layer is etched to form the source and drain contacts.

Referring now to FIG. 6, the contact nitride layer 114 is patterned and etched to remove corresponding portions of the contact nitride layer 114 and the passivation layer 106 to create a source void 116 to allow for the source contact to be deposited on the substrate 102 and a drain void 118 to allow for the drain contact to be deposited on the substrate 102. (Alternatively, a drain contact could be deposited in void 116 and a source contact could be deposited in void 118.)

In an alternative embodiment, a second passivation layer (not illustrated) (which may, for example, be made of the same or different material as the passivation layer 106) is present. In an embodiment, the second passivation layer is deposited after definition of the gate sealing oxide layer 108 and is conformal to the underlying structure.

In an embodiment, the second passivation layer is etched together with the dielectric layer 114 when defining the voids for the contact metallizations. In an embodiment, the second passivation layer remains under the dielectric layer 114 after definition of the above said voids.

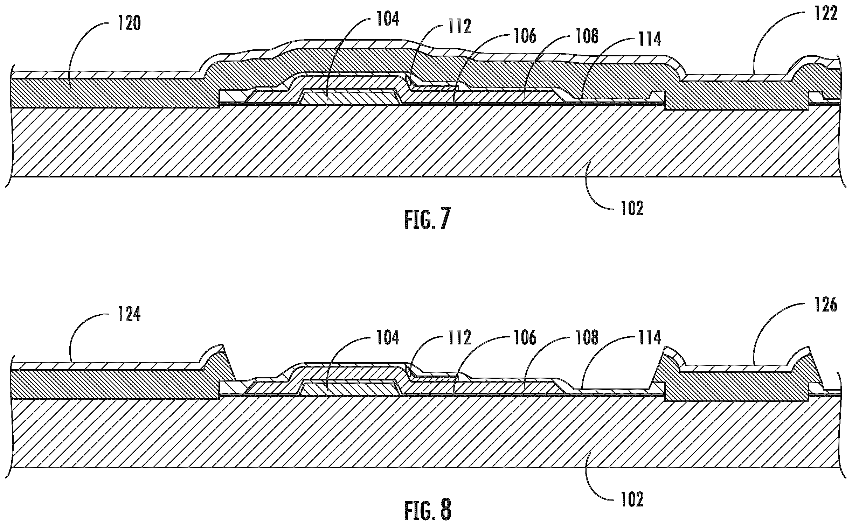

Referring now to FIG. 7, a contact layer 120 and another metallic layer 122 have been deposited. In an embodiment, the contact layer 120 and the metallic layer 122 are a metallic stack deposited in a single deposition step, and comprise, for example, Titanium (Ti), Titanium Nitride (TiN), Aluminum Copper (AlCu), and/or other materials used in conventional aluminum interconnects. Referring now to FIG. 8, the contact layer 120 and the metallic layer 122 have been patterned and etched to expose the area around the gate structure 104 and form the source contact 124 and the drain contact 126. (Alternatively, contact 124 could be a drain contact and contact 126 could be a source contact.)

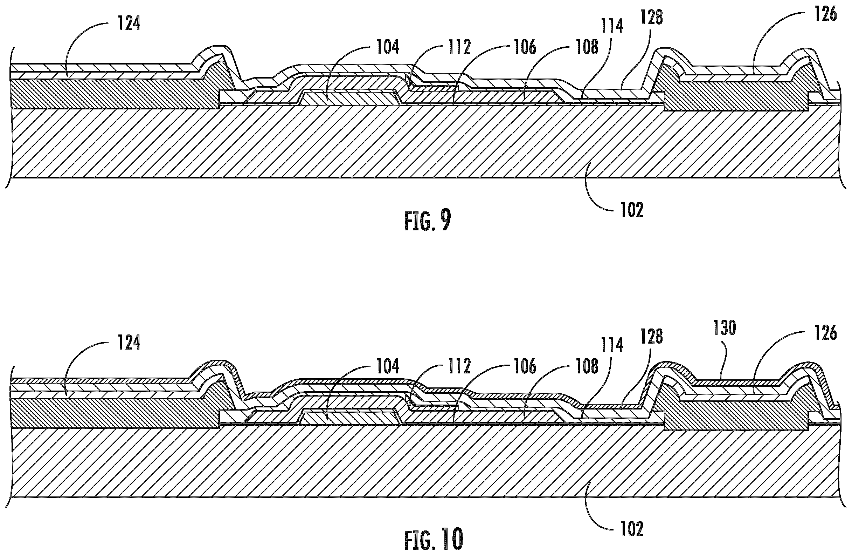

Referring now to FIG. 9, the dielectric layer further comprises a second dielectric sub-layer such as a sealing nitride layer 128, which is deposited on the source/drain metallizations 124 and 126, and the first dielectric sub-layer. The sealing nitride layer 128 comprises, for example, SiN. This layer protects the metallic layer on top of the source contact 124 and the drain contact 126.

In an embodiment, the sealing nitride layer is not directly etched to enable field plate formation, unlike other approaches that have been used. As such, the necessity of accurately placing the mask, and the implied and related issues of controlling the photolithography process, to create a SiN opening is avoided. In alternative embodiments (not shown), the dielectric layer consists of the first dielectric sub-layer (i.e., does not comprise the second dielectric sub-layer).

Referring now to FIG. 10, a metallic layer 130 is deposited over the sealing nitride layer 128. The metallic layer 130 comprises, for example, TiN. The above-described problem of residue remaining at the vertical or concave walls of the ohmic (drain & source) metallizations may be reduced or avoided by applying the metallic layer 130 with low thickness (for example, about 20-60 nanometers) and/or applying with a process (such as physical vapor deposition) that provides low step coverage.

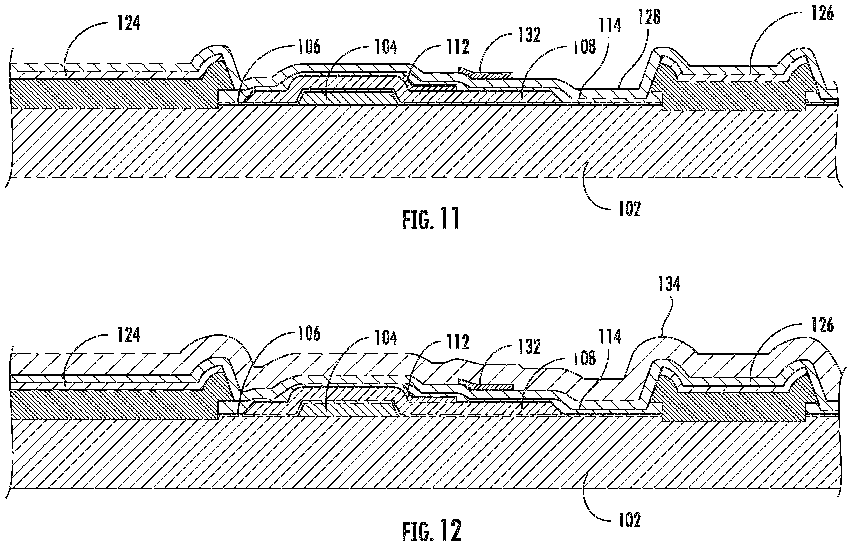

Referring now to FIG. 11, the metallic layer is patterned and etched to create a second field plate 132 by removing all of the metallic layer 130 except for the portion that forms the second field plate 132. The above-described problem of residue remaining at the vertical or concave walls of the ohmic (drain & source) metallizations may be further reduced or avoided by using an isotropic etching process to remove the unneeded portions of the metallic layer 130. In an embodiment, it is possible to bias the two field plates at two different voltages. For example, the thickness of the first and second field plates ranges from 20 nm to 100 nm, which in some cases, are thinner than in the case of a single field plate. In the illustrated embodiment, the first and second field plates do not overlap.

In an alternative embodiment, the first and second field plates may partially overlap. For example, it is possible to leave further portions of the metallic materials from which the first and second field plates originate. These further portions can be used as a passive component, for example can be used as electrodes for a MIM (metal-insulator-metal) capacitor structure (e.g., the dielectric layer acting as the insulation layer between the two metallic plates). In the case of a MIM capacitor, the further portions are overlapped to each other.

Referring now to FIG. 12, a gate contact dielectric layer (typically made of oxide material, and therefore called gate contact dielectric oxide layer 134 below) is deposited over the second field plate 132 and portions of the sealing nitride layer 128. The gate contact dielectric oxide layer 134 comprises, for example, SiO₂.

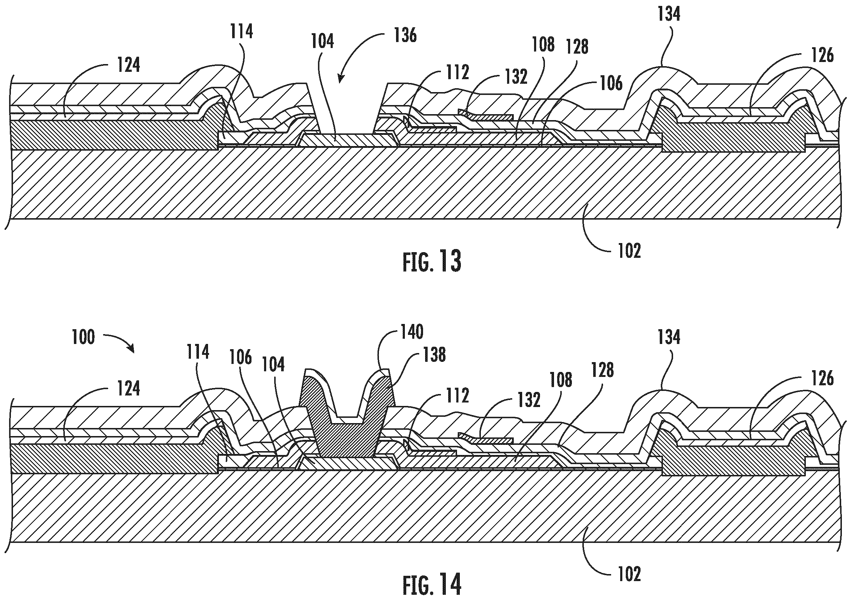

Referring now to FIG. 13, a three-step etching process is performed to remove the gate contact dielectric oxide layer 134, the sealing nitride layer 128, the sealing oxide layer 108, and the passivation layer 106 over the gate structure 104, creating a gate void 136. The selectivity of etching an oxide over SiN and etching SiN over an oxide enables better control of the final etch step.

Subsequently, a gate contact is formed on top of the gate structure 104 to form the completed device shown in FIG. 14. FIG. 14 illustrates a GaN semiconductor device 100 according to an embodiment of the present disclosure. In the device 100 of FIG. 14, a contact layer 138 and another metallic layer 140 have been deposited and then patterned and etched to remove unneeded material to form the gate contact 142. In an embodiment, the contact layer 138 and the metallic layer 140 are a metallic stack deposited in a single deposition step, and comprise, for example, Titanium (Ti), Titanium Nitride (TiN), Aluminum Copper (AlCu), and/or other materials used in conventional aluminum interconnects. The process integration of embodiments of the present disclosure advantageously allows to form the gate contact metallization 142 (i.e., the contact layer 138 and the metallic layer 140) after the first field plate is formed, thereby providing a dedicated process with improved precision and/or accuracy.

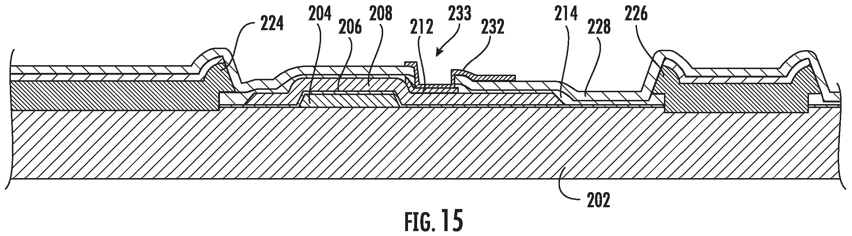

FIG. 15 is a schematic cross-sectional view illustrating a step of an example method of manufacturing a semiconductor device, in accordance with an alternative embodiment of the present disclosure. Similar to the steps described in relation to FIGS. 1-9 above, FIG. 15 shows the following formed on a substrate 202: a gate structure 204, a passivation layer 206, a sealing oxide layer 208, a first field plate 212, contact nitride layer 214, a source contact 224, a drain contact 226, and sealing nitride layer 228. After the sealing nitride layer 228 is deposited, the sealing nitride layer 228 is patterned and etched to remove portions of the sealing nitride layer 228 to create a second field plate void 233. A metallic layer (not illustrated) is deposited and then patterned and etched to create a second field plate 232 by removing all of the metallic layer except for the portion that forms the second field plate 232. In the alternative embodiment of FIG. 15, the second field plate 232 has a (exemplarily center) portion that contacts the first field plate 212. By having the first field plate and the second field plate directly connected as shown in FIG. 15, it is possible to bias the first and second field plate at the same potential, avoiding the formation of one or more vias.

The layers of the semiconductor device described herein (e.g., the passivation layer, the sealing oxide layer, the metallic layers, the contact nitride layers, the gate contact dielectric oxide layer) may be formed using any suitable technique for forming layers on a semiconductor device, such as, but not limited to, physical vapor deposition or chemical vapor deposition.

Embodiments of the invention provide a semiconductor device and method of manufacturing a semiconductor device involving a 100-volt integrated circuit. Alternative embodiments of the invention provide a semiconductor device and method of manufacturing a semiconductor device involving higher voltage ratings.

### Conclusion

Finally, it is clear that modifications and variations may be made to what has been described and illustrated herein without thereby departing from the scope of the present invention, as defined in the attached claims.

For example, the disclosed embodiments relate primarily to structures for GaN HEMT devices, however, one skilled in the art may recognize that such principles may be applied to other semiconductor devices.

. For example, the same teaching may apply to other forms of semiconductor devices, such as power LDMOS (laterally-diffused metal-oxide semiconductor) devices in BCD (Bipolar-CMOS-DMOS) platforms in which a double field plate is used.

In particular the present invention may be summarized as it follows.

In one aspect of the invention, is provided a semiconductor device comprising:
a substrate made of a semiconductor material;
a gate structure placed on the substrate;
a passivation layer placed on the substrate and on a portion of the gate structure;
a sealing dielectric layer placed on the passivation layer, wherein the sealing dielectric layer is thicker than the passivation layer;
a first field plate placed on a portion of the sealing dielectric layer;
a dielectric layer placed on the first field plate and on the sealing dielectric layer;
a second field plate placed on a portion of the dielectric layer; and
a source contact metallization and a drain contact metallization.

In a further aspect of the semiconductor device, the sealing dielectric layer and the dielectric layer are made of a nitride or an oxide material.

In a further aspect of the semiconductor device, the source contact metallization and the drain contact metallization are formed on corresponding portions of the substrate in corresponding voids in the passivation layer, the sealing dielectric layer, and the dielectric layer.

In a further aspect of the semiconductor device, the dielectric layer comprises a first dielectric sub-layer and a second dielectric sub-layer.

In a further aspect of the semiconductor device, said first dielectric sub-layer is partially overlapped by the source and drain contact metallizations.

In a further aspect of the semiconductor device, said second dielectric sub-layer overlaps the source and drain contact metallizations.

In a further aspect of the semiconductor device, the semiconductor device further comprises a gate contact dielectric layer placed on the second field plate and on a portion of the dielectric layer.

In a further aspect of the semiconductor device, the semiconductor device further comprises a gate contact metallization placed on the gate structure in a void in the gate contact dielectric layer, the dielectric layer, the sealing dielectric layer, and the passivation layer.

In a further aspect of the semiconductor device, the gate structure is made of gallium nitride (GaN); and the semiconductor device comprises a GaN high electron mobility transistor.

In a further aspect of the semiconductor device, the second field plate partially contacts the first field plate through a further void in the dielectric layer.

In another aspect of the invention, is provided a method of manufacturing a semiconductor device, the method comprising:
forming a gate structure on a substrate made of a semiconductor material;
forming a passivation layer on the substrate and on a portion of the gate structure;
forming a sealing dielectric layer on the passivation layer, wherein the sealing dielectric layer is thicker than the passivation layer;
forming a first field plate on a portion of the sealing dielectric layer;
forming a dielectric layer on the first field plate and on the sealing dielectric layer;
forming a second field plate on a portion of the dielectric layer; and
forming a source contact metallization and a drain contact metallization.

In a further aspect of the method, the sealing dielectric layer and the dielectric layer are made of a nitride or an oxide material.

In a further aspect of the method, the source contact metallization and the drain contact
metallization are formed on corresponding portions of the substrate in corresponding voids in the passivation layer, the sealing dielectric layer, and the dielectric layer.

In a further aspect of the method, the dielectric layer comprises a first dielectric sub-layer and a second dielectric sub-layer.

In a further aspect of the method, said first dielectric sub-layer is partially overlapped by the source and drain contact metallizations.

In a further aspect of the method, said second dielectric sub-layer overlaps the source and drain contact metallizations.

In a further aspect of the method, the method further comprises forming a gate contact dielectric layer placed on the second field plate and on a portion of the dielectric layer.

In a further aspect of the method, the method further comprises:
forming a gate contact metallization on the gate structure in a void in the gate contact dielectric layer, the dielectric layer, the sealing dielectric layer, and the passivation layer.

In a further aspect of the method, the gate contact metallization is formed after the first field plate is formed.

In a further aspect of the method, the second field plate partially contacts the first field plate through a further void in the dielectric layer.

## Claims

1. A semiconductor device (100) comprising:
a substrate (102; 202) made of a semiconductor material;
a gate structure (104; 204) placed on the substrate (102; 202);
a passivation layer (106; 206) placed on the substrate (102; 202) and on a portion of the gate structure (104; 204);
a sealing dielectric layer (108; 208) placed on the passivation layer (106; 206), wherein the sealing dielectric layer (108; 208) is thicker than the passivation layer (106; 206);
a first field plate (112; 212) placed on a portion of the sealing dielectric layer (108; 208);
a dielectric layer (114, 128; 214, 228) placed on the first field plate (112; 212) and on the sealing dielectric layer (108; 208);
a second field plate (132; 232) placed on a portion of the dielectric layer (114, 128; 214, 228); and
a source contact metallization (124; 224) and a drain contact metallization (126; 226).

2. The semiconductor device of claim 1, wherein the sealing dielectric layer (108; 208) and the dielectric layer (114, 128; 214, 228) are made of a nitride or an oxide material.

3. The semiconductor device of any of claims 1 or 2, wherein the source contact metallization (124; 224) and the drain contact metallization (126; 226) are formed on corresponding portions of the substrate (102; 202) in corresponding voids in the passivation layer (106; 206), the sealing dielectric layer (108; 208), and the dielectric layer (114, 128; 214, 228).

4. The semiconductor device of any of claims 1-3, wherein the dielectric layer (114, 128; 214, 228) comprises a first dielectric sub-layer (114; 214) partially overlapped by the source (124; 224) and drain contact metallizations (126; 226) and a second dielectric sub-layer (128; 228) overlapping the source (124; 224) and drain contact metallizations (126; 226).

5. The semiconductor device of any of claims 1-4, wherein the passivation layer (106; 206) has a thickness in the range from 5 nm to 10 nm and the sealing dielectric layer (108; 208) has a thickness in the range from 30 nm to 120 nm.

6. The semiconductor device of any of claims 1-5, further comprising a gate contact dielectric layer (134) placed on the second field plate (132; 232) and on a portion of the dielectric layer (114, 128; 214, 228) and a gate contact metallization (138) placed on the gate structure (104; 204) in a void (136) in the gate contact dielectric layer (134), the dielectric layer (114, 128; 214, 228), the sealing dielectric layer (108; 208), and the passivation layer (106; 206).

7. The semiconductor device of any of claims 1-6, wherein the gate structure (104; 204) is made of gallium nitride (GaN); and wherein the semiconductor device (100) comprises a GaN high electron mobility transistor.

8. The semiconductor device of any of claims 1-7, wherein the second field plate (232) partially contacts the first field plate (212) through a further void (233) in the dielectric layer (114, 128; 214, 228).

9. A method of manufacturing a semiconductor device (100), the method comprising:
forming a gate structure (104; 204) on a substrate (102; 202) made of a semiconductor material;
forming a passivation layer (106; 206) on the substrate (102; 202) and on a portion of the gate structure (104; 204);
forming a sealing dielectric layer (108; 208) on the passivation layer (106; 206), wherein the sealing dielectric layer (108; 208) is thicker than the passivation layer (106; 206);
forming a first field plate (112; 212) on a portion of the sealing dielectric layer (108; 208);
forming a dielectric layer (114, 128; 214, 228) on the first field plate (112; 212) and on the sealing dielectric layer (108; 208);
forming a second field plate (132; 232) on a portion of the dielectric layer (114, 128; 214, 228); and
forming a source contact metallization (124; 224) and a drain contact metallization (126; 226).

10. The method of claim 9, wherein the sealing dielectric layer (108; 208) and the dielectric layer (114, 128; 214, 228) are made of a nitride or an oxide material.

11. The method of any of claims 9 or 10, wherein the source contact metallization (124; 224) and the drain contact metallization (126; 226) are formed on corresponding portions of the substrate (102; 202) in corresponding voids in the passivation layer (106; 206), the sealing dielectric layer (108; 208), and the dielectric layer (114, 128; 214, 228).

12. The method of any of claims 9-11, wherein the dielectric layer (114, 128; 214, 228) comprises a first dielectric sub-layer (114; 214) partially overlapped by the source (124; 224) and drain contact metallizations (126; 226) and a second dielectric sub-layer (128; 228) overlapping the source (124; 224) and drain contact metallizations (126; 226).

13. The method of any of claims 9-12, further comprising a gate contact dielectric layer (134) placed on the second field plate (132; 232) and on a portion of the dielectric layer (114, 128; 214, 228) and a gate contact metallization (138) placed on the gate structure (104; 204) in a void (136) in the gate contact dielectric layer (134), the dielectric layer (114, 128; 214, 228), the sealing dielectric layer (108; 208), and the passivation layer (106; 206).

14. The method of claim 13, wherein the gate contact metallization (138) is formed after the first field plate (112; 212) is formed.

15. The method of any of claims 9-14, wherein the second field plate (232) partially contacts the first field (212) plate through a further void (233) in the dielectric layer (114, 128; 214, 228).
